# EUROPEAN PATENT APPLICATION

(11) **EP 4 542 333 A1**
(43) Date of publication of application: **23.04.2025**
(21) Application number: 24173192.6
(22) Date of filing: 29.04.2024
(51) Int. Cl.: G06F 1/16, G04B 37/00, G04B 47/04

(54) **WEARABLE DEVICE**

(30) Priority: 17.10.2023 CN 202311345103
(71) Applicant: Beijing Xiaomi Mobile Software Co., Ltd., Beijing 100085 (CN)
(72) Inventor: LIU, Bei, Beijing, 100085 (CN)
(74) Representative: Dehns Germany Partnerschaft mbB

(57) **Abstract**

The disclosure relates to a wearable device (1), including: a fixed structure (100); a processor(10), where the processor is installed on the fixed structure; and a detachable structure (200), where the detachable structure is installed on the fixed structure in a detachable mode, at least one group of inductive pieces (20) are arranged on the detachable structure, each group of inductive pieces includes at least one inductive element (30), and at least one sensor (40) is arranged on the fixed structure. The sensor is configured to detect the inductive element at a corresponding position, different types of at least one group of inductive pieces (20) are arranged on different types of detachable structures (200), and the processor (10) is in communication connection with the sensor (40) so as to adjust a display of the wearable device (1) according to a detection result of the sensor (40).

## Description

### TECHNICAL FIELD

The disclosure relates to the technical field of electronic devices, in particular to a wearable device.

### BACKGROUND

With the rapid development of information technology, there is a constant stream of new advancements in wearable devices. Currently, a body of a wearable device generally includes a fixed structure and a detachable structure. When the detachable structure of the wearable device is being replaced, a display of the wearable device typically remains unchanged, which is not conducive to the coordination between the detachable structure and the display of the wearable device.

### SUMMARY

In order to solve the existing problem in the related art, the disclosure provides a wearable device..

According to a first aspect of the present invention, there is provided a wearable device, including: a fixed structure; a processor, where the processor is installed on the fixed structure; and a detachable structure. The detachable structure is installed on the fixed structure in a detachable mode, at least one group of inductive pieces are arranged on the detachable structure, each group of inductive pieces includes at least one inductive element, and at least one sensor is arranged on the fixed structure. The sensor is configured to detect the inductive element at a corresponding position, different types of at least one group of inductive pieces are arranged on different types of detachable structures, and the processor is in communication connection with the sensor so as to adjust a display of the wearable device according to a detection result of the sensor.

Optionally, the inductive element is structured as a magnetic piece, and the sensor is structured as a Hall device.

Optionally, at least two groups of inductive pieces are arranged on the detachable structure, the at least two groups of inductive pieces are arranged at intervals in a circumferential direction of the detachable structure, and any two groups of inductive pieces are arranged in a rotationally symmetric mode, where in the any two groups of inductive pieces, poles of two corresponding magnetic pieces arranged in a rotationally symmetric mode are the same.

Optionally, the detachable structure has an installing structure configured to install each group of inductive pieces, and the installing structure includes at least two installing grooves used to install the magnetic pieces, where a quantity of the Hall devices equals a quantity of the installing grooves in the installing structure, and a quantity of the magnetic pieces of each group of inductive pieces is smaller than a quantity of the installing grooves in the installing structure.

Optionally, the detachable structure has an installing structure configured to install each group of inductive pieces, and the installing structure includes at least two installing grooves used to install the magnetic pieces, where a quantity of the Hall devices equals a quantity of the installing grooves in the installing structure, and a quantity of the magnetic pieces of each group of inductive pieces equals a quantity of the installing grooves in the installing structure.

Optionally, the fixed structure has an annular matching part, and the detachable structure is rotatably sleeved in the annular matching part. A first turnbuckle is arranged on the annular matching part, a second turnbuckle is arranged on the detachable structure, and the first turnbuckle and the second turnbuckle are clamped together in a rotatably fastening mode.

Optionally, the fixed structure has an annular matching part, and the detachable structure is rotatably sleeved in the annular matching part. A flexible piece is arranged on one of the annular matching part and the detachable structure, and the flexible piece abuts against the other of the annular matching part and the detachable structure.

Optionally, the flexible piece is arranged on the detachable structure, the flexible piece has a first wall surface, and the first wall surface is used to abut against the fixed structure in an axial direction.

Optionally, the flexible piece is arranged on the detachable structure, the flexible piece has a second wall surface, and the second wall surface is used to abut against the annular matching part in a radial direction.

Optionally, the fixed structure has an annular matching part, and the detachable structure is rotatably sleeved in the annular matching part. An elastic sheet is arranged on the detachable structure, the elastic sheet has a first protrusion that protrudes inwardly, the annular matching part is provided with a second protrusion that protrudes outwardly, and when the detachable structure rotates, the first protrusion selectively abuts against the second protrusion.

Through the above technical solution, in the wearable device provided by the disclosure, because the wearable device includes the fixed structure and the detachable structure and the detachable structure can be installed on the fixed structure in a detachable mode, the wearable device can realize that different types of detachable structures are replaced on the same fixed structure, thus achieving detaching of the detachable structure. In addition, because the inductive element is arranged on the detachable structure, the sensor is arranged on the fixed structure, and the sensor can detect the inductive element at the corresponding position, when the detachable structure is installed on the fixed structure, the sensor can detect the inductive element corresponding to the current detachable structure, the processor adjusts a display of the wearable device according to a detection result of the sensor so that the display of the wearable device matches with the current detachable structure. On this basis, different types of at least one group of inductive pieces are arranged on different types of detachable structures, that is, the different types of detachable structures have different types of inductive pieces. Thus, according to the wearable device of the disclosure, automatically adjusting the display of the wearable device can further be easily achieved during replacement of the detachable structure and operation is convenient.

Other features and advantages of the disclosure will be described in detail in the subsequent detailed description part.

### BRIEF DESCRIPTION OF DRAWINGS

The accompanying drawings here are incorporated into and form a part of the specification, illustrate examples consistent with the disclosure, and are used in conjunction with the specification to explain the principles of the disclosure.
Fig. 1 is a first partially explosive view of a wearable device provided by some examples of the disclosure.
Fig. 2 is a second partially explosive view of a wearable device provided by some examples of the disclosure.
Fig. 3 is a schematic structural diagram of a fixed structure provided by some examples of the disclosure.
Fig. 4 is a three-dimensional view of a fixed structure provided by some examples of the disclosure.
Fig. 5 is a schematic structural diagram of a detachable structure provided by some examples of the disclosure.
Fig. 6 is a three-dimensional view of a detachable structure provided by some examples of the disclosure.
Fig. 7 is a three-dimensional view of a flexible piece and an elastic sheet provided by some examples of the disclosure.
Fig. 8 is an explosive view of a wearable device provided by some examples of the disclosure.

### DETAILED DESCRIPTION

Some examples of the invention are described in detail below in conjunction with the accompanying drawings. It is to be understood that some examples described here are merely used to illustrate and explain the invention and are not used to limit the invention.

In the invention, in the absence of any indication to the contrary, the use of orientation terms such as "inside and outside" is defined based on a radial direction of a detachable or fixed structure to mean that the direction along the radius of the detachable or fixed structure towards the center of the circle is inside, and the direction along the center of the circle to the radius is outside. The terms "first" and "second" are used to distinguish one element from another and do not have sequentiality or significance. In addition, the following description refers to the accompanying drawings in such a way that the same reference numerals in the different drawings indicate the same or similar elements.

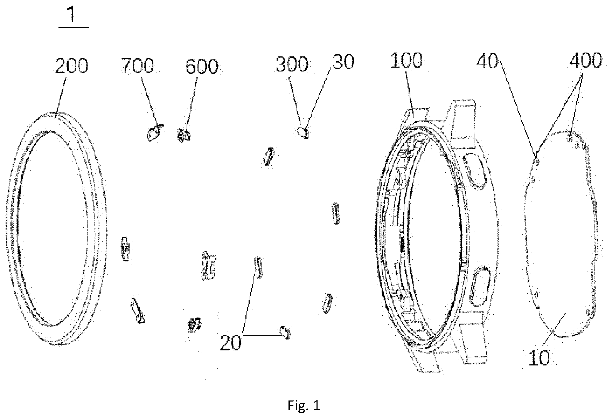

According to some examples of the invention, a wearable device 1 is provided. As shown in Fig. 1, the wearable device 1 includes: a fixed structure 100; a processor10, where the processor 10 is installed on the fixed structure 100; and a detachable structure 200, the detachable structure 200 is installed on the fixed structure 100 in a detachable mode, at least one group of inductive pieces 20 are arranged on the detachable structure 200, each group of inductive pieces 20 includes at least one inductive element 30, and at least one sensor 40 is arranged on the fixed structure 100. The sensor 40 is configured to detect the inductive element 30 at a corresponding position, different types of at least one group of inductive pieces 20 are arranged on different types of detachable structure 200, and the processor 10 is in communication connection with the sensor 40 so as to adjust a display of the wearable device 1 according to a detection result of the sensor 40.

Through the above technical solution, in the wearable device 1 provided by the invention, because the wearable device 1 includes the fixed structure 100 and the detachable structure 200, and the detachable structure 200 can be installed on the fixed structure 100 in a detachable mode, the wearable device 1 can realize that the different types of detachable structures 200 are replaced on the same fixed structure 100, thus achieving detaching of the detachable structure 200. In addition, because the inductive element 30 is arranged on the detachable structure 200, the sensor 40 is arranged on the fixed structure 100, and the sensor 40 can detect the inductive element 30 at the corresponding position, when the detachable structure 200 is installed on the fixed structure 100, the sensor 40 can detect the inductive element 30 corresponding to the current detachable structure 200, and the processor 10 adjusts a display of the wearable 1 device according to a detection result of the sensor 40 so that the display of the wearable device 1 matches with the current detachable structure 200. On this basis, the different types of at least one group of inductive pieces 20 are arranged on the different types of detachable structures 200, that is, the different types of detachable structures 200 have different types of inductive pieces. Thus, according to the wearable device 1 of the invention, automatically adjusting the display of the wearable device 1 can further be easily achieved during replacement of the detachable structure 200 and operation is convenient.

It needs to be noted that, the "different types of detachable structures 200" may refer to detachable structures 200 in different appearances. An appearance of the detachable structure 200 at least includes at least one of a color, a shape, a material, etc. of the detachable structure 200. In other words, the "different types of detachable structures 200" may refer to detachable structures 200 different in at least one of the color, the shape, or the material. In addition, the "detection result" may be a type of the detachable structure detected by the sensor 40, that is, the sensor 40 may detect the type of the detachable structure through detecting the type of the at least one group of inductive pieces 20. In addition, the "the display of the wearable device 1" may refer to display information on a touch control display screen in the wearable device 1.

In the invention, the processor 10 may further adjust at least one of the display, vibration, and sound of the wearable device 1 according to the detection result. The processor 10 may adjust at least one of display information of a dial plate, audio information broadcast by a speaker, or vibration information triggered by a motor according to the detection result, or may adjust a combination of any two of them, or may adjust the display information, audio information broadcast by the speaker and vibration information triggered by the motor at the same time. The above "dial plate" here may refer to information displayed on a display interface of the wearable device 1.

The "detachable structure" and the "fixed structure" here refer to the "detachable structure" and the "fixed structure" included in a body of the wearable device 1. For example, the "detachable structure" may refer to a watch bezel of the body of the wearable device 1, and the "fixed structure" may refer to a middle frame of the body of the wearable device 1. In addition, "different types of at least one group of inductive pieces 20 are arranged on different types of detachable structures 200" refers to that, at least one group of inductive pieces 20 may be arranged on the detachable structures 200, and for the same type of detachable structure 200, the inductive elements 30 at the same positions in each group of inductive pieces 20 are the same; and for the different types of detachable structures 200, in each group of inductive pieces 20, the inductive elements 30 at at least one same position are different, or at the same position, there may be a case that an inductive element 30 is arranged in one group while no inductive element 30 is arranged in another group.

In some examples of the invention, the inductive elements 30 and the sensor 40 may be structured in any suitable mode. In some examples, the inductive elements 30 may be structured as magnetic pieces 300, the sensor 40 may be structured as a Hall device 400, and the Hall device 400 is configured to detect magnetic pole information of the magnetic piece 300 at the corresponding position. It needs to be noted here that, the "different types of at least one group of inductive pieces 20" may refer to that the magnetic pole information of the magnetic pieces 300 in different types of at least one group of inductive pieces 20 is different. In some examples, the Hall device 400 may detect the type of the at least one group of inductive pieces 20 through detecting the magnetic pole information of the magnetic pieces 300, thus detecting the type of the detachable structure, and transmit a detection result, i.e. the detected type of the detachable structure, to the processor 10, and the processor 10 adjusts the display of the wearable device 1. In some examples, during replacement of different types of detachable structures 200, the detachable structures 200 rotate relative to the fixed structure 100, so the magnetic pieces 300 and the Hall device 400 rotate from deflected positions with a relatively large distance to positions corresponding to each other. In a process when the magnetic pieces 300 gradually approach the Hall device 400, a magnetic field strength of the magnetic pieces 300 is higher than a threshold value required by the Hall device 400 so that the Hall device 400 can generate a Hall effect. At the moment, the Hall device 400 detects the magnetic pole information of the magnetic pieces 300 at the corresponding position.

In other examples, the inductive elements 30 may be structured as structural members, the sensor 40 may be structured as an image recognition sensor, and the structural members may be protrusions. It needs to be noted here that, the "different types of at least one group of inductive pieces 20" may refer to a case that the protrusions in the different types of at least one group of inductive pieces 20 are different in shape or quantity. In the example, the image recognition sensor may detect the type of the at least one group of inductive pieces 20 by detecting the shapes or quantity of the protrusions, thus detecting the type of the detachable structure, and transmit a detection result, i.e. the type of the detachable structure, to the processor 10, and the processor 10 adjusts the display of the wearable device 1.

In some examples of the invention, the inductive pieces 20 may be structured in any suitable mode. In some examples, as shown in Fig. 1, Fig. 5 and Fig. 6, at least two groups of inductive pieces 20 may be arranged on the detachable structure 200, the at least two groups of inductive pieces 20 may be arranged at intervals in a circumferential direction of the detachable structure 200, and any two groups of inductive pieces 20 may be arranged in a rotationally symmetric mode. In the any two groups of inductive pieces 20, poles of two corresponding magnetic pieces 300 arranged in a rotationally symmetric mode may be the same. That is, in the same type of detachable structure 200, the magnetic pole information of the magnetic pieces 300 in each group of inductive pieces 20 is the same. In this way, during installation of the detachable structure 200, it is merely needed to make the positions of the magnetic pieces 300 in any one group of inductive pieces 20 correspond to that of the Hall device 400, and the Hall device 400 can detect the magnetic pole information of the corresponding magnetic pieces 300 so as to determine the type of the current detachable structure 200.

In addition, it needs to be noted that, "any two groups of inductive pieces 20 may be arranged in a rotationally symmetric mode" may refer to a case that any two groups of inductive pieces 20 are at the same interval angle. In this way, during installation of the detachable structure 200, installation may be completed when the detachable structure 200 is rotated by at most one interval angle relative to the fixed structure 100. On the one hand, a rotation degree of the detachable structure 200 during installation may be reduced, and installation is convenient; and on the other hand, compared to the arrangement of merely one group of inductive pieces 20, the above arrangement can prevent the situation that in an installed wearable device 1, the Hall device 400 fails to recognize the type of the current detachable structure 200 because the magnetic pieces 300 and the Hall device 400 are at non-corresponding positions. For example, when a quantity of the inductive pieces 20 is three groups, "any two groups of inductive pieces 20 may be arranged in a rotationally symmetric mode" may refer to a case that any two groups of inductive pieces 20 are at the same interval angle of 120°. During installation of the detachable structure 200, installation may be completed when the detachable structure 200 is rotated by at most 120° relative to the fixed structure 100. At the same time, after installation of the detachable structure 200, there is always one group of inductive pieces 20 among the three groups of inductive pieces 20 at the position corresponding to the position of the Hall device 400, so the situation that the inductive pieces 20 and the Hall device 400 are at non-corresponding positions and the angular difference between the inductive pieces 20 and the Hall device 400 is 120° or 240° will not be caused.

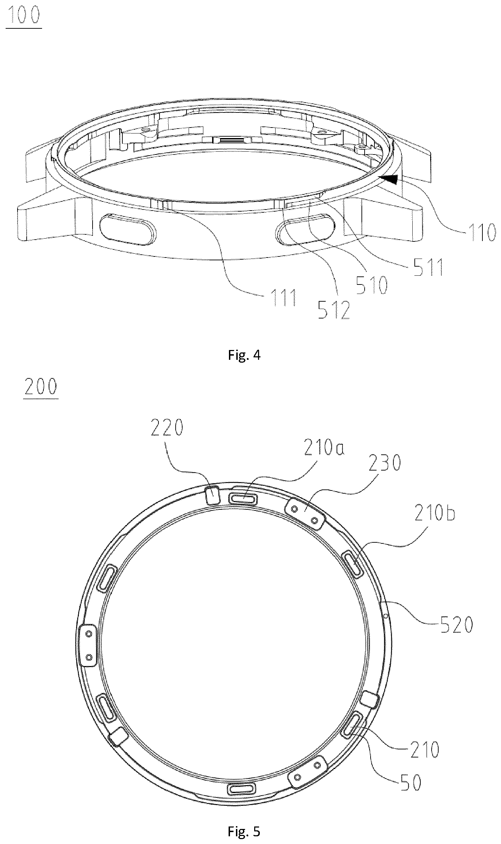

In some examples of the invention, the magnetic pieces 300 in each group of inductive pieces 20 may be structured in any suitable mode. In some examples, as shown in Fig. 5 to Fig. 6, the detachable structure 200 may have an installing structure 50 configured to install each group of inductive pieces 20, and the installing structure 50 may include at least two installing grooves 210 used to install the magnetic pieces 300, where a quantity of the Hall devices 400 may equal a quantity of the installing grooves 210 in the installing structure 50, and a quantity of the magnetic pieces 300 of each group of inductive pieces 20 may be smaller than a quantity of the installing grooves 210 in the installing structure 50. In other words, there may be a case that in at least one installing groove 210, no magnetic piece 300 is installed. For example, when a quantity of the installing grooves 210 in the installing structure 50 is two (respectively labeled as the first installing groove 210a and the second installing groove 210b here), "the quantity of the magnetic pieces 300 of each group of inductive pieces 20 may be smaller than a quantity of the installing grooves 210 in the installing structure 50" refers to a case that a quantity of the magnetic piece 300 in each group of inductive pieces 20 is one, that is, the magnetic piece 300 is installed in one of the first installing groove 210a and the second installing groove 210b, and no magnetic piece 300 is installed in the other of the two. Because the magnetic pole information of the magnetic pieces 300 includes an N pole and an S pole, when a quantity of the installing grooves 210 in the installing structure 50 is two, there will be four different types of corresponding detachable structures 200 as follows.

I. The magnetic piece 300 is installed in the first installing groove 210a, and in a case of completing installation of the detachable structure 200, the N pole of the magnetic piece 300 can be detected by the Hall device 400; and no magnetic piece 300 is installed in the second installing groove 210b. In this case, the type of the detachable structure 200 is recorded as a first detachable structure, and the corresponding magnetic pole information detected by the Hall device 400 is: N/. II. The magnetic piece 300 is installed in the first installing groove 210a, and in a case of completing installation of the detachable structure 200, the S pole of the magnetic piece 300 can be detected by the Hall device 400; and no magnetic piece 300 is installed in the second installing groove 210b. In this case, the type of the detachable structure 200 is recorded as a second detachable structure, and the corresponding magnetic pole information detected by the Hall device 400 is: S/. III. No magnetic piece 300 is installed in the first installing groove 210a, the magnetic piece 300 is installed in the second installing groove 210b, and in a case of completing installation of the detachable structure 200, the N pole of the magnetic piece 300 can be detected by the Hall device 400. In this case, the type of the detachable structure 200 is recorded as a third detachable structure, and the corresponding magnetic pole information detected by the Hall device 400 is: /N. IV. No magnetic piece 300 is installed in the first installing groove 210a, the magnetic piece 300 is installed in the second installing groove 210b, and in a case of completing installation of the detachable structure 200, the S pole of the magnetic piece 300 can be detected by the Hall device 400. In this case, the type of the detachable structure 200 is recorded as a fourth detachable structure, and the corresponding magnetic pole information detected by the Hall device 400 is: /S.

In some other examples, the detachable structure 200 may have the installing structure 50 configured to install each group of inductive pieces 20, and the installing structure 50 may include at least two installing grooves 210 used to install the magnetic pieces 300, where a quantity of the Hall devices 400 may equal a quantity of the installing grooves 210 in the installing structure 50, and a quantity of the magnetic pieces 300 of each group of inductive pieces 20 may equal a quantity of the installing grooves 210 in the installing structure. In other words, the magnetic piece 300 is installed in each installing groove 210. For example, when a quantity of the installing grooves 210 in the installing structure 20 is two (respectively labeled as the first installing groove 210a and the second installing groove 210b here), "the quantity of the magnetic pieces 300 of each group of inductive pieces 20 may equal a quantity of the installing grooves 210 in the installing structure 50" refers to a case that a quantity of magnetic pieces 300 in each group of inductive pieces 20 is two, that is, the magnetic pieces 300 are installed in both the first installing groove 210a and second installing groove 210b. Because the magnetic pole information of the magnetic pieces 300 includes an N pole and an S pole, when a quantity of the installing grooves 210 in the installing structure 50 is two, there will be four different types of corresponding detachable structures 200 as follows.

I. The magnetic pieces 300 are installed in both the first installing groove 210a and second installing groove 210b, and in a case of completing installation of the detachable structure 200, the N pole of the magnetic piece 300 in the first installing groove 210a and the N pole of the magnetic piece 300 in the second installing groove 210b can be respectively detected by the corresponding Hall device 400. In this case, the type of the detachable structure 200 is recorded as a fifth detachable structure, and the corresponding magnetic pole information detected by the Hall device 400 is: NN. II. The magnetic pieces 300 are installed in both the first installing groove 210a and second installing groove 210b, and in a case of completing installation of the detachable structure 200, the N pole of the magnetic piece 300 in the first installing groove 210a and the S pole of the magnetic piece 300 in the second installing groove 210b can be respectively detected by the corresponding Hall device 400. In this case, the type of the detachable structure 200 is recorded as a sixth detachable structure, and the corresponding magnetic pole information detected by the Hall device 400 is: NS. III. The magnetic pieces 300 are installed in both the first installing groove 210a and second installing groove 210b, and in a case of completing installation of the detachable structure 200, the S pole of the magnetic piece 300 in the first installing groove 210a and the N pole of the magnetic piece 300 in the second installing groove 210b can be respectively detected by the corresponding Hall device 400. In this case, the type of the detachable structure 200 is recorded as a seventh detachable structure, and the corresponding magnetic pole information detected by the Hall device 400 is: SN. IV. The magnetic pieces 300 are installed in both the first installing groove 210a and second installing groove 210b, and in a case of completing installation of the detachable structure 200, the S pole of the magnetic piece 300 in the first installing groove 210a and the S pole of the magnetic piece 300 in the second installing groove 210b can be respectively detected by the corresponding Hall device 400. In this case, the type of the detachable structure 200 is recorded as an eighth detachable structure, and the corresponding magnetic pole information detected by the Hall device 400 is: SS.

In other examples, installing groups 210 in other suitable quantity may also be arranged in the installing structure 50. For example, a quantity of the installing grooves 210 in the installing structure 50 may be three, four, etc., which is not specifically limited in the invention. At the same time, a quantity of the Hall devices 400 may equal a quantity of the installing grooves 210, and a quantity of the magnetic pieces 300 may be smaller than or equal a quantity of the installing grooves 210.

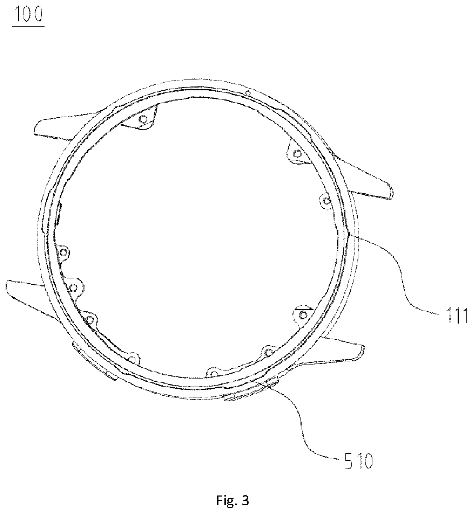

In some examples of the invention, the detachable structure 200 may be installed on the fixed structure 100 in a detachable mode in any suitable way. In some examples, as shown in Fig. 3 to Fig. 6, the fixed structure 100 may have an annular matching part 110, and the detachable structure 200 may be rotatably sleeved in the annular matching part 110. A first turnbuckle 510 may be arranged on the annular matching part 110, a second turnbuckle 520 may be arranged on the detachable structure 200, and the first turnbuckle 510 and the second turnbuckle 520 may be clamped together in a rotatably fastening mode. The first turnbuckle 510 may be arranged as one of a fastener or a clamping groove, and the second turnbuckle 520 may be arranged as the other. In this way, when the detachable structure 200 rotates relative to the annular matching part 110, the fastener can also rotate relative to the clamping groove and be clamped in the clamping groove. On the one hand, installation of the detachable structure 200 and the fixed structure 100 can be realized through rotation, and operation is convenient; and on the other hand, detachment of the detachable structure 200 from the fixed structure 100 can be prevented, and it is ensured that the detachable structure 200 is firmly installed.

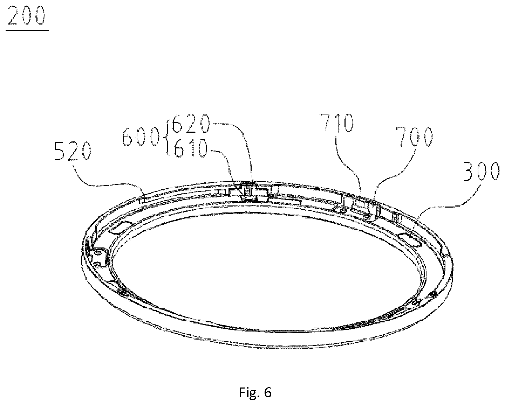

In the example, as shown in Fig. 4, an L-shaped baffle may be arranged on an outer side wall of the annular matching part 110, the L-shaped baffle may include a first stopping part 511 and a second stopping part 512, and the first stopping part 511, the second stopping part 512 and a frame body of the fixed structure 100 may jointly define a U-shaped clamping groove with an open end. The U-shaped clamping groove is arranged in a circumferential direction of the annular matching part 110 so as to be used as the first turnbuckle 510. As shown in Fig. 6, blocking chunks may be arranged on an inner side wall of the detachable structure 200, the blocking chunks may be arranged in the circumferential direction of the detachable structure 200 so as to be used as the second turnbuckle 520. In this way, when the detachable structure 200 rotates relative to the fixed structure 100, the blocking chunks (that is, the second turnbuckle 520) can also rotate relative to the U-shaped clamping groove (that is, the first turnbuckle 510) so as to enter the U-shaped clamping groove (that is, the first turnbuckle 510) from the open end of the U-shaped clamping groove (that is, the first turnbuckle 510). At the moment, the first stopping part 511 and the frame body of the fixed structure 100 can jointly restrict the blocking chunks (that is, the second turnbuckle 520) from moving in an axial direction of the detachable structure 200 relative to the U-shaped clamping groove (that is, the first turnbuckle 510), that is, restricting the detachable structure 200 from being detached from the fixed structure 100 along the axial direction of the detachable structure 200. In addition, through the arrangement of the second stopping part 512, the blocking chunks (that is, the second turnbuckle 520) can be restricted from further rotating relative to the U-shaped clamping groove (that is, the first turnbuckle 510), that is, the detachable structure 200 is restricted from further rotating relative to the fixed structure 100, which reminds an operator of completing installation of the detachable structure 200. It needs to be noted that, when the blocking chunks abut against the second stopping part 512, the detachable structure 200 and the fixed structure 100 are in an installed status, and at the moment, each Hall device 400 can also detect the magnetic pole information of the corresponding magnetic piece 300.

In addition, in the example, a quantity of the first turnbuckles 510 and second turnbuckles 520 may be plural, the first turnbuckles 510 and second turnbuckles 520 may be arranged respectively in one-to-one correspondence. The plurality of first turnbuckles 510 may be arranged at intervals in the circumferential direction of the annular matching part 110, and the plurality of second turnbuckles 520 may be arranged at intervals in the circumferential direction of the detachable structure 200. In this way, one circumference of the detachable structure 200 may be firmly installed on the fixed structure 100 through the first turnbuckles 510 and second turnbuckles 520, thus increasing connection stability. In other examples, the first turnbuckles 510 and second turnbuckles 520 may also be structured in other suitable modes, which is not restricted in the invention.

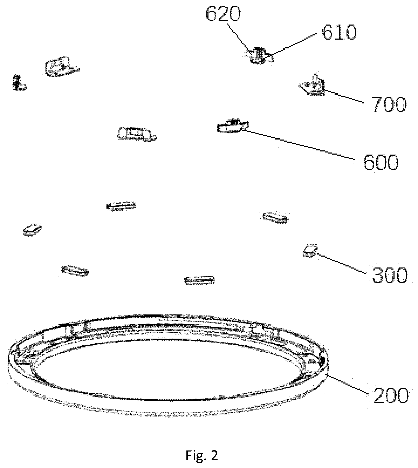

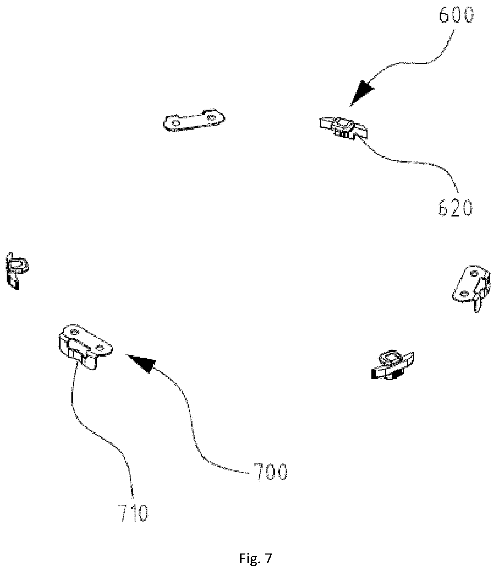

In some examples of the invention, in order to reduce friction between the fixed structure 100 and the detachable structure 200, in some examples, referring to Fig. 2, and as shown in Fig. 6 to Fig. 7, the fixed structure 100 may have the annular matching part 110, the detachable structure 200 may be rotatably sleeved in the annular matching part 110, a flexible piece 600 may be arranged on one of the annular matching part 110 and the detachable structure 200, and the flexible piece 600 may abut against the other of the annular matching part 110 and the detachable structure 200. In this way, the flexible piece 600 may be arranged between the annular matching part 110 and the detachable structure 200, and offer buffering during relative rotation between the annular matching part 110 and the detachable structure 200, thus preventing hard contact between the annular matching part 110 and the detachable structure 200, and reducing wearing between the annular matching part 110 and the detachable structure 200. In the example, a first locating groove 220 for installing the flexible piece 600 may be formed on the detachable structure 200, the flexible piece 600 may be partially accommodated in the first locating groove 220 and be bonded in the first locating groove 220 through glue dispensing, so that an installing position of the flexible piece 600 can be conveniently determined in a processing course. In addition, in the example, a quantity of the flexible piece 600 may be plural, and the plurality of flexible pieces 600 are arranged at intervals in the circumferential direction of the detachable structure 200. In this way, an effect of comprehensive protection may be achieved on the circumference of the detachable structure 200.

The flexible piece 600 may be structured in any suitable mode. In some examples, as shown in Fig. 2 and Fig. 6, the flexible piece 600 may be arranged on the detachable structure 200, the flexible piece 600 may have a first wall surface 610, and the first wall surface 610 may be used to abut against the fixed structure 100 in an axial direction. In this way, the first wall surface 610 may prevent hard contact between the annular matching part 110 and the detachable structure 200 in the axial direction.

In addition, as shown in Fig. 2, Fig. 6 and Fig. 7, the flexible piece 600 may be arranged on the detachable structure 200, the flexible piece 600 may have a second wall surface 620, and the second wall surface 620 may be used to abut against the annular matching part 110 in a radial direction. In this way, the second wall surface 620 can prevent hard contact between the annular matching part 110 and the detachable structure 200 in a radial direction.

In some examples of the invention, referring to Fig. 3 to Fig. 4, and as shown in Fig. 6 to Fig. 7, the fixed structure 100 may have the annular matching part 110, the detachable structure 200 may be rotatably sleeved in the annular matching part 110, an elastic sheet 700 may be arranged on the detachable structure 200, the elastic sheet 700 may have a first protrusion 710 that protrudes inwardly, a second protrusion 111 that protrudes outwardly may be arranged on the annular matching part 110, and when the detachable structure 200 rotates, the first protrusion 710 may selectively abut against the second protrusion 111. In this way, in a process of rotation of the detachable structure 200 relative to the fixed structure 100, the elastic sheet 700 is in contact with the second protrusion 111, and at the moment the elastic sheet 700 can move outward in the radial direction of the detachable structure 200 under an abutting effect of the second protrusion 111; and when installation of the detachable structure 200 is completed, the elastic sheet 700 can bypass the second protrusion 111, and at the moment, the elastic sheet 700 can move inward in the radial direction of the detachable structure 200 under an elastic effect of the elastic sheet and strike the annular matching part 110 to cause vibration and make a sound, which reminds the operator of completed installation of the detachable structure 200. In addition, through the arrangement of the first protrusion 710 that protrudes inwardly on the elastic sheet 700, when the first protrusion 710 abuts against the second protrusion 111, a distance between the elastic sheet 700 and the annular matching part 110 can be enlarged, so a striking degree of the elastic sheet 700 against the annular matching part 110 is also clearer. In the example, a quantity of the elastic sheet 700 and the second protrusion 111 may be set to be one or plural, and the elastic sheet 700 and the second protrusion 111 are arranged in one-to-one correspondence. When there is a plurality of elastic sheets 700, the plurality of elastic sheets 700 may be distributed at intervals in the circumferential direction of the detachable structure 200. In this way, a reminding effect for the operator caused by the elastic sheets 700 may be further enhanced.

In the example, the first protrusion 710 and the second protrusion 111 may be arranged in an arc shape on both sides, which facilitates the situation that the elastic sheet 700 is in smooth contact with the second protrusion 111 during rotation, and elastic deformation is caused to prevent clamping of the elastic sheet 700. In addition, a second locating groove 230 for installing the elastic sheet 700 may be arranged on the detachable structure 200, the elastic sheet 700 may be partially accommodated in the second locating groove 230 and be installed in the second locating groove 230 through laser welding or other modes, and in this way, an installing position of the elastic sheet 700 can be conveniently determined in a processing course.

In some other examples, two second protrusions 111 (not shown in the drawings) may also be arranged. In this way, after completing installation of the detachable structure 200, the elastic sheet 700 can be located between the two second protrusions 111. On the one hand, the purpose of reminding the operator through vibration and sounds can be achieved, and on the other hand, over rotation of the detachable structure 200 by the operator can be prevented through restricting the position of the elastic sheet 700 by the two second protrusions 111.

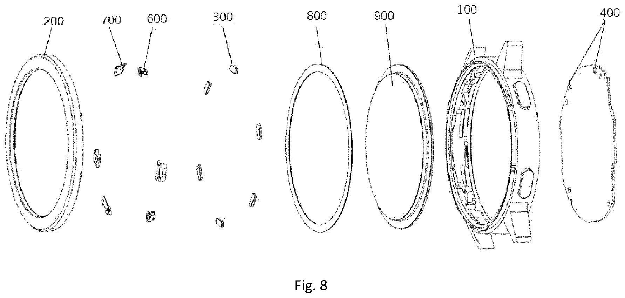

On the basis of the above solution, as shown in Fig. 8, the wearable device 1 may further include an installing ring 800 and a cover plate 900. The cover plate 900 may be arranged on the fixed structure 100 in a shading mode. In this way, the cover plate 900 can provide protection for the wearable device 1 so as to prevent the wearable device 1 from knocking damage. The installing ring 800 may be arranged between the cover plate 900 and the detachable structure 200. In this way, the detachable structure 200 can be prevented from scratching the cover plate 900 in a rotating process. In addition, a third locating groove for installing the installing ring 800 may further be formed in the detachable structure 200.

In summary, during replacement of the detachable structure 200 of the wearable device 1, the operator may rotate the detachable structure 200 to achieve rotatable fastening between the first turnbuckle 510 and the second turnbuckle 520, and a reminding sound made by the elastic sheet 700 and vibration indicate that the detachable structure 200 has been installed in place; and at the moment, it is no longer needed to rotate the detachable structure 200. The Hall device 400 can detect the magnetic pole information of the corresponding magnetic piece 300 so as to determine the type of the current detachable structure 200. Then the processor 10 may adjust the display of the wearable device 1 according to a detection result of the Hall device 400. In this way, instant switching of the corresponding display of the wearable device 1 may be realized during replacement of different types of detachable structures.

## Claims

1. A wearable device (1), comprising:
a fixed structure (100);
a processor (10), installed on the fixed structure (100); and
a detachable structure (200), installed on the fixed structure (100) in a detachable mode,
wherein at least one group of inductive pieces (20) are arranged on the detachable structure (200), each group of inductive pieces (20) comprises at least one inductive element (30), and at least one sensor (40) is arranged on the fixed structure (100), wherein the sensor (40) is configured to detect the inductive element (30) at a corresponding position, different types of the at least one group of inductive pieces (20) are arranged on different types of detachable structures (200), and the processor (10) is in communication connection with the sensor (40) so as to adjust a display of the wearable device (1) according to a detection result of the sensor (40).

2. The wearable device (1) according to claim 1, wherein the inductive element (30) is structured as a magnetic piece (300), the sensor (40) is structured as a Hall device (400), and the Hall device (400) is configured to detect magnetic pole information of the magnetic piece (300) at a corresponding position.

3. The wearable device (1) according to claim 2, wherein at least two groups of inductive pieces (20) are arranged on the detachable structure (200), at least two groups of the inductive pieces (20) are arranged at intervals in a circumferential direction of the detachable structure (200), and any two groups of inductive pieces (20) are arranged in a rotationally symmetric mode, wherein in the any two groups of inductive pieces (20), magnetic poles of two corresponding magnetic pieces (300) arranged in a rotationally symmetric mode are the same.

4. The wearable device (1) according to claim 3, wherein the detachable structure (200) has an installing structure (50) configured to install each group of inductive pieces (20), and the installing structure (50) comprises at least two installing grooves (210) used to install the magnetic pieces (300), wherein a quantity of the Hall devices (400) is equal to a quantity of the installing grooves (210) in the installing structure (50), and a quantity of the magnetic pieces (300) of each group of inductive pieces (20) is smaller than a quantity of the installing grooves (210) in the installing structure (50).

5. The wearable device (1) according to claim 3, wherein the detachable structure (200) has an installing structure (50) configured to install each group of inductive pieces (20), and the installing structure (50) comprises at least two installing grooves (210) used to install the magnetic pieces (300), wherein a quantity of the Hall devices (400) equals a quantity of the installing grooves (210) in the installing structure (50), and a quantity of the magnetic pieces (300) of each group of inductive pieces (20) equals a quantity of the installing grooves (210) in the installing structure (50).

6. The wearable device (1) according to any one of claims 1 to 5, wherein the fixed structure (100) has an annular matching part (110), and the detachable structure (200) is rotatably sleeved in the annular matching part (110), and
a first turnbuckle (510) is arranged on the annular matching part (110), a second turnbuckle (520) is arranged on the detachable structure (200), and the first turnbuckle (510) and the second turnbuckle (520) are clamped together in a rotatably fastening mode.

7. The wearable device (1) according to any one of claim 1 to 6, wherein the fixed structure (100) has an annular matching part (110), and the detachable structure (200) is rotatably sleeved in the annular matching part (110), and
a flexible piece (600) is arranged on one of the annular matching part (110) and the detachable structure (200), and the flexible piece (600) abuts against the other of the annular matching part (110) and the detachable structure (200).

8. The wearable device (1) according to claim 7, wherein the flexible piece (600) is arranged on the detachable structure (200), the flexible piece (600) has a first wall surface (610), and the first wall surface (610) is used to abut against the fixed structure (100) in an axial direction.

9. The wearable device (1) according to claim 7 or 8, wherein the flexible piece (600) is arranged on the detachable structure (200), the flexible piece (600) has a second wall surface (620), and the second wall surface (620) is used to abut against the annular matching part (110) in a radial direction.

10. The wearable device (1) according to any one of claim 1 to 9, wherein the fixed structure (100) has an annular matching part (110), and the detachable structure (200) is rotatably sleeved in the annular matching part (110), and
an elastic sheet (700) is arranged on the detachable structure (200), the elastic sheet (700) has a first protrusion (710) that protrudes inwardly, the annular matching part (110) is provided with a second protrusion (111) that protrudes outwardly, and in response to determining that the detachable structure (200) rotates, the first protrusion (710) selectively abuts against the second protrusion (111).
